# EUROPÄISCHE PATENTSCHRIFT

(11) **EP 0 393 338 B1**
(45) Veröffentlichungstag und Bekanntmachung des Hinweises auf die Patenterteilung: **08.06.1994**
(21) Anmeldenummer: 90104303.4
(22) Anmeldetag: 07.03.1990
(51) Int. Cl.: H01P 1/00, H01P 1/04

(54) **Anordnung zum Kontaktieren einer planaren Mikrowellenschaltung in einem Hohlleiter oder Gehäuse**
Device for contacting a planar microwave circuit in a waveguide or a housing
Disposition pour contacter un dispositif hyperfréquence dans un guide d'ondes ou un boîtier

(30) Priorität: 15.04.1989 DE 3912481
(43) Veröffentlichungstag der Anmeldung: 24.10.1990
(73) Patentinhaber: ANT Nachrichtentechnik GmbH, D-71522 Backnang (DE)
(72) Erfinder: Mörz, Günter, Dr.-Ing., D-7140 Ludwigsburg (DE); Speldrich, Werner, D-7150 Backnang (DE)

(56) Entgegenhaltungen:
- CA-A- 991 374
- DE-A- 2 258 557
- DE-A- 2 629 107
- DE-A- 3 629 745
- DE-B- 1 234 288
- GB-A- 2 193 848
- DE-A1-2 540 186

## Beschreibung

Die vorliegende Erfindung betrifft eine Anordnung zum Herstellen eines Kontaktes zwischen einem aus einem Boden-und einem Deckelteil bestehenden Hohlleiter oder Gehäuse und einer darin eingesetzten planaren Mikrowellenschaltung, wobei das Boden- und das Deckelteil an mindestens einer Seitenwand des Hohlleiters oder Gehäuses eine nutartige Vertiefung bilden, die zur Aufnahme eines elektrisch leitenden Federelements dient, welches den Kontakt zwischen dem Hohlleiter oder Gehäuse und der planaren Mikrowellenschaltung herstellt.

Eine derartige Anordnung geht beispielsweise aus der DE 25 40 186 A1 hervor. Hierbei stellt ein Federelement einen Kontakt zwischen der Massefläche eines mit einer Schaltung versehenen Substrats und einem zweiteiligen Gehäuse her. Das Federelement ist ein Blech etwa von der Größe des zu kontaktierenden Substrats. An seinen Rändern ist das Blech eingerollt, und die eingerollten, elastisch verformbaren Ränder sind zusammen mit den Rändern des Substrats in Nuten an den Gehäuseinnenwänden eingeklemmt. Dabei liegt die Masseseite des Substrats auf den eingerollten federnden Rändern des Blechs auf, und auf die gegenüberliegende Substratseite übt ein Absatz der Nut Druck aus.

Der Erfindung liegt die Aufgabe zugrunde, eine Kontaktierungsanordnung der eingangs genannten Art anzugeben, die mit möglichst geringem Aufwand herstellbar ist und einen dauerhaft sicheren Kontakt zwischen den Hohlleiter- oder Gehäuseteilen und einer darin eingesetzten planaren Mikrowellenschaltung gewährleistet.

Erfindungsgemäß wird diese Aufgabe durch die Merkmale des Anspruch 1 gelöst. Zweckmäßige Ausbildungen der Erfindung gehen aus den Unteransprüchen hervor.

Als besonders vorteilhaft erweist sich die Kontaktierungsanordnung der Erfindung bei planaren Mikrowellenschaltungen mit spröden Substraten (z.B. aus Quarzglas), da jeglicher harte Klemmdruck, der von den Hohlleiter- oder Gehäuseteilen ausgeht, von dem Substrat ferngehalten wird. Die Kontaktierungsanordnung vermeidet aufgrund ihrer Elastizität, daß spröde Substrate durch zu großen Kontaktdruck zerstört werden, eine gute Kontaktierung aber trotzdem gegeben ist.

Anhand mehrerer in der Zeichnung dargestellter Ausführungsbeispiele wird nun die Erfindung näher erläutert.
- Figur 1: zeigt einen Schnitt durch einen Hohlleiter mit einer darin von einer Kontaktierungsanordnung gehaltenen planaren Mikrowellenschaltung,
- Figur 2: zeigt einen Querschnitt einer anderen Kontaktierungsanordnung und
- Figur 3: zeigt einen Schnitt durch einen Hohlleiter, in dem sich eine planare Mikrowellenschaltung mit einer direkt an ihrem Rand angeformten Kontaktierungsanordnung befindet.

Die hier angesprochenen planaren Mikrowellenschaltungen sind z.B. auf dielektrischen Substraten aufgebrachte Streifenleiter- oder Finleitungsstrukturen. Solche Substrate können aus weichem oder hartem dielektrischen Material bestehen. Die Kontaktierung eines weichen Substrats in einem in einer E-Feld-Ebene geteilten Hohlleiter kann, wie der DE 36 29 745 A1 zu entnehmen ist, durch Ausnutzen der elastischen Verformbarkeit des Substratmaterials zwischen die beiden Hohlleiterteile eingeklemmt werden. Diese Art der Kontaktierung läßt sich auf harte Substrate nicht anwenden.

Die in dieser Anmeldung erwähnten planaren Mikrowellenschaltungen sollen aber auch rein leitende Platten umfassen, de z. B., versehen mit einer bestimmten Aussparungsstruktur und in einem Hohlleiter eingesetzt, ein Filter realisieren oder als Trennbleche in einem Hohlleiter eine Polarisationsweiche bilden.

Hohlleiter oder Gehäuse, in denen planare Mikrowellenschaltungen eingesetzt werden, sind in der Regel zweigeteilt. Die zwei Hohlleiter- oder Gehäuseteile werden im folgenden als Boden- und als Deckelteil bezeichnet. Die anschließende Beschreibung von drei Ausführungsbeispielen behandelt die Kontaktierung von planaren Mikrowellenschaltungen in Hohlleitern. Auf die Kontaktierung von planaren Mikrowellenschaltungen in Gehäusen, die nicht Hohlleiter sind, muß nicht gesondert eingegangen werden, da sie für Hohlleiter und anders geartete Gehäuse gleich ist.

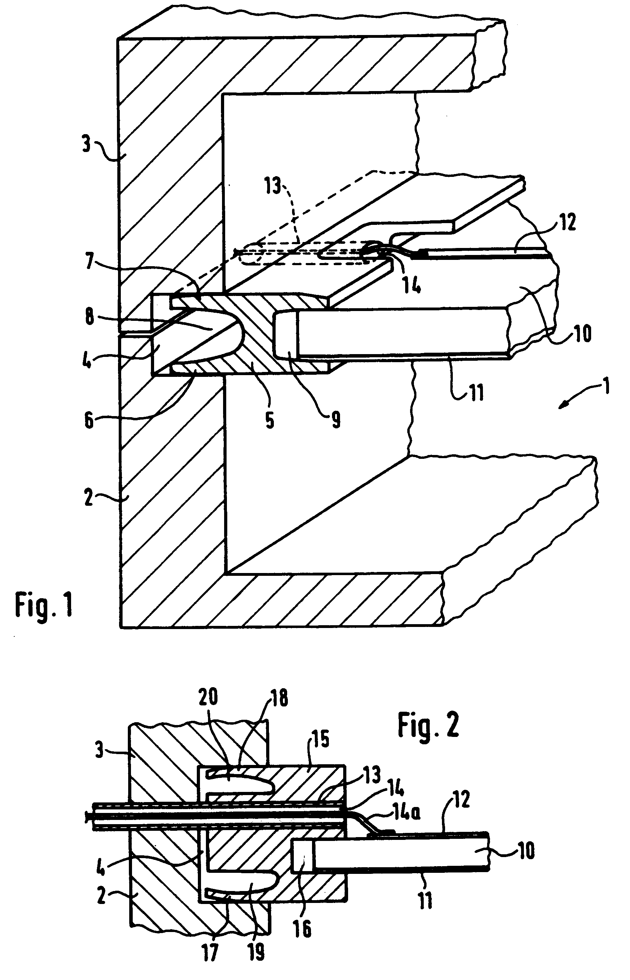

In den Figuren 1, 2 und 3 ist jeweils ein Ausschnitt eines aus einem Bodenteil 2 und einem Deckelteil 3 bestehenden Hohlleiters 1 im Querschnitt dargestellt. Durch Aussparungen an der in der Ebene des elektrischen Feldes liegenden Trennstelle des Hohlleiters 1 bilden das Bodenteil 2 und das Deckelteil 3 zusammen eine Nut 4 für den Einsatz einer Kontaktierungsanordnung. Da hier davon ausgegangen wird, daß der Hohlleiter 1 symmetrisch ist, d.h. an beiden einander gegenüberliegenden Innenwänden die gleiche Nut mit der gleichen Kontaktierungsanordnung vorgesehen ist, beschränken sich die Zeichnungen auf die Darstellung der Kontaktierung einer planaren Mikrowellenschaltung an nur einer Seite des Hohlleiters.

Die der Figur 1 zu entnehmende Kontaktierungsanordnung ist ein als Profilleiste ausgeführtes elektrisch leitendes Federelement 5. Es weist an seiner in die Nut 4 des Hohlleiters 1 eingesteckten Längsseite zwei federnde Lippen 6 und 7 auf, von denen die eine federnde Lippe 6 in der Nut 4 gegen das Bodenteil 2 und die andere federnde Lippe 7 in entgegengesetzte Richtung gegen das Deckelteil 3 drückt. Über die beiden mit den Innenwänden der Nut 4 Linienkontakte bildenden federnden Lippen 6, 7 stellt das Federelement 5 einen zuverlässigen elektrischen Kontakt zwichen dem Bodenteil 2 und dem Deckelteil 3 des Hohlleiters 1 her. Die zwei parallel verlaufenden, langgestreckten federnden Lippen 6 und 7 entstehen durch Einbringen einer U-förmigen Aussparung 8 in einer Längsseite des Federelements 5. Dabei bilden die beiden U-Schenkel die besagten Lippen 6 und 7. Die von den Lippen 6, 7 entfaltete Federkraft hängt von deren Material und Dicke ab. Um einem Erlahmen der Federkraft der Lippen 6, 7 entgegenzutreten, sollte in der U-förmigen Aussparung 8 der Übergang auf die U-Schenkel abgerundet werden. Die damit verbundene Materialverstärkung der Lippen 6, 7 an Stellen, wo die größten Biegekräfte auftreten, vermeidet ein Abknicken der Lippen.

In der den federnden Lippen 6, 7 gegenüberliegenden, in das Hohlleiterinnere weisenden Längsseite des Federelements 5 erstreckt sich eine Nut 9, in die eine planare Mikrowellenschaltung 10 - hier z.B. ein dielektrisches Substrat mit einer Masseleitung 11 auf der Unterseite und einer Streifenleitungsstruktur 12 auf der Oberseite - mit ihrem Rand eingesetzt wird. Über die Begrenzungswände der Nut 9, die eventuell auch federnd auf die Ober- und Unterseite des Substrats 10 aufliegen, erfolgt eine Kontaktgabe zwischen der Masseleitung 11 des Substrats 10, dem Bodenteil 2 und dem Deckelteil 3 des Hohlleiters 1. Sollte die Verbindung zwischen dem Substrat 10 und dem Federelement 5 aufgrund der Klemmwirkung der Begrenzungswände der Nut 9 nicht ausreichen, so kann die Masseleitung 11 in der Nut 9 zusätzlich angelötet werden.

Das beschriebene Federelement 5 kann, wie in Figur 1 angedeutet, mit einer oder mehreren Leitungsdurchführungen versehen werden, worüber die planare Mikrowellenschaltung mit HF-Signalen oder Gleichstrom versorgt werden kann. Für eine solche Leitungsdurchführung ist das Federelement 5 mit einem Durchbruch 13 versehen, der sich von der die federnden Lippen 6, 7 aufweisenden Längsseite her zur gegenüberliegenden Längsseite und zwar zwischen den federnden Lippen 6, 7 einerseits und den Begrenzungswänden der Nut 9 andererseits erstreckt. Eine durch den Durchbruch 13 geführte koaxiale Leitung 14, welche durch eine Öffnung in der Hohlleiterwand eintritt, ist mit ihrem Innenleiter 14a an einen Streifenleiter 12 der planaren Mikrowellenschaltung angeschlossen. Die Koaxialleitung 14 kann beispielsweise als halbstarres Kalbel (semi-rigid-line") ausgeführt sein, dessen Außenleiter in den Durchbruch 13 des Federelements 5 eingelötet ist.

Ein gegenüber dem in Figur 1 dargestellten Federelement 5 geringfügig abgewandeltes Federelement 15 zeigt die Figur 2. Hier sind eine die planare Mikrowellenschaltung 10 aufnehmende Nut 16 und ein quer dazu verlaufender, als Leitungsdurchführung dienender Durchbruch 17 übereinander und nicht wie beim Federelement 5 gemäß Figur 1 in einer Ebene angeordnet. Aus diesem Grund hat das Federelement 15 insgesamt eine größere Höhe. Deshalb liegen auch die federnden Lippen 18 und 19 an der anderen Längsseite des Federelements 15 weiter auseinander. In dieser Längsseite erstrecken sich zwei parallel zueinander verlaufende U-förmige Aussparungen 19 und 20, wobei die jeweils außen liegenden, einander nicht benachbarten U-Schenkel die beiden federnden Lippen 19, 20 bilden. Aus dem oben bereits genannten Grund ist der Übergang einer jeden U-förmigen Aussparung 19, 20 auf seinen eine federnde Lippe 17, 18 darstellenden U-Schenkel abgerundet.

Die als Federelement 5, 15 verwendete Profilleiste läßt sich mit ihren Aussparungen 8, 19, 20 und Nuten 9, 16 in einem Strangpreßverfahren bzw. Ziehverfahren auf einfache Weise herstellen.

Die federnden Lippen 6, 7 und 17, 18 können natürlich abweichend von der gezeichneten Form gestaltet werden; die gezeichnete Form bietet jedoch den Vorteil, daß ein Linienkontakt mit dem Hohlleiter bzw. dem Gehäuse gebildet wird und keinerlei Umwege für die zu kontaktierenden Ströme gebildet werden.

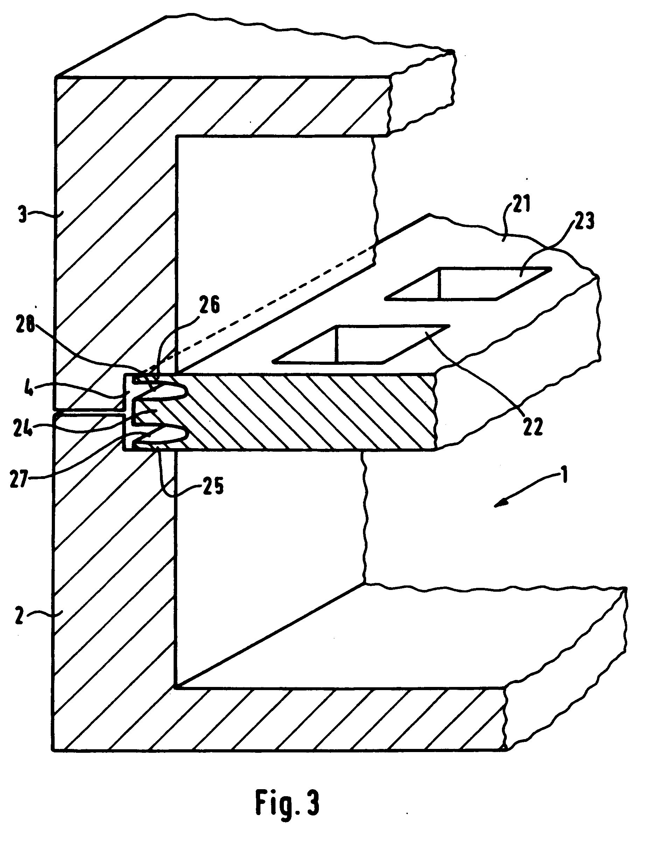

Bei dem in Figur 3 gezeigten Ausführungsbeispiel ist in den Hohlleiter 1 eine Metallplatte 21 eingesetzt, in der mehrere Ausnehmungen 22, 23 vorhanden sind zur Erzielung einer Filterfunktion (Insert-Filter). Bei einer solchen Metallplatte 21 wird zweckmäßigerweise das Federelement mit seinen zwei federnden Lippen 25 und 26 direkt am Rand angeformt. Je nachdem wie dick die Metallplatte ist, können die federnden Lippen 25, 26 durch Einbringen einer oder zweier U-förmiger Aussparungen 27, 28 realisiert werden.

## Patentansprüche

1. Anordnung zum Herstellen eines Kontaktes zwischen einem aus einem Boden- (2) und einem Deckelteil (3) bestehenden Hohlleiter (1) oder Gehäuse und einer darin eingesetzten planaren Mikrowellenschaltung (10), wobei das Boden- (2) und das Deckelteil (3) an mindestens einer Seitenwand des Hohlleiters (1) oder Gehäuses eine nutartige Vertiefung (4) bilden, die zur Aufnahme eines elektrisch leitenden Federelements (5; 15; 24) dient, welches den Kontakt zwischen dem Hohlleiter (1) oder Gehäuse und der planaren Mikrowellenschaltung (10) herstellt, dadurch gekennzeichnet, daß das Federelement (5; 15; 24) an seiner für den Einsatz in die nutartige Vertiefung (4) bestimmten Seite zwei federnde Lippen (6, 7; 17, 18; 25, 26) aufweist, von denen die eine innerhalb der nutartigen Vertiefung (4) gegen das Bodenteil (2) und die andere in entgegengesetzte Richtung gegen das Deckelteil (3) drückt, und daß die den federnden Lippen (6, 7; 17, 18; 25, 26) gegenüberliegende Seite des Federelements (5; 15; 24) für die Verbindung mit der planaren Mikrowellenschaltung (10, 21) ausgebildet ist.

2. Anordnung nach Anspruch 1, dadurch gekennzeichnet, daß das Federelement (5) eine Profilleiste ist, in deren einer Längsseite eine langgestreckte U-förmige Aussparung (8) vorhanden ist, wobei die beiden U-Schenkel die federnden Lippen (6, 7) bilden.

3. Anordnung nach Anspruch 1, dadurch gekennzeichnet, daß das Federelement (15) eine Profilleiste ist, in deren einer Längsseite sich zwei parallel verlaufende U-förmige Aussparungen (19, 20) erstrecken, wobei die jeweils außen liegenden, einander nicht benachbarten U-Schenkel der Aussparungen die beiden federnden Lippen (17, 18) bilden.

4. Anordnung nach Anspruch 2 oder 3, dadurch gekennzeichnet, daß in jeder U-förmigen Aussparung (8, 19, 20, 27, 28) der Übergang auf den eine federnde Lippe (6, 7; 17, 18; 25, 26) bildenden U-Schenkel abgerundet ist.

5. Anordnung nach Anspruch 1, 2 oder 3, dadurch gekennzeichnet, daß in die den federnden Lippen (6, 7; 17, 18) gegenüberliegende Längsseite des Federelements (5; 15) eine längs verlaufende Nut (9; 16) eingelassen ist, worin die planare Mikrowellenschaltung (10) mit einem Rand hineingesteckt und ein Kontakt zwischen der Masseleitung (11) in der Randzone der planaren Mikrowellenschaltung und dem Federelement (5; 15) hergestellt wird.

6. Anordnung nach Anspruch 5, dadurch gekennzeichnet, daß die einander gegenüberliegenden Begrenzungswände der Nut (9) federnd auf der Ober- und der Unterseite der planaren Mikrowellenschaltung (10) aufliegen.

7. Anordnung nach einem der vorhergehenden Ansprüche, dadurch gekennzeichnet, daß das Federelement (5; 15) mindestens einen sich von der mit den federnden Lippen (6, 7; 17, 18) versehenen Längsseite zur gegenüberliegenden, mit der planaren Mikrowellenschaltung (10) kontaktierbaren Längsseite erstreckenden Durchbruch (13) aufweist, der zur Durchführung eines durch eine Hohlleiter- (1) oder Gehäusewand eintretenden Leiters (14a) dient, welche für den Anschluß an die planare Mikrowellenschaltung (10) bestimmt ist.

8. Anordnung nach Anspruch 1, 2 oder 3, dadurch gekennzeichnet, daß bei einer in einen Hohlleiter (1) oder ein Gehäuse einzusetzenden planaren Mikrowellenschaltung (10) in Gestalt einer Metallplatte (21) mindestens an einem Rand dieser Metallplatte (21) ein Federelement (24) mit zwei federnden Lippen (25, 26) direkt angeformt ist.

## Claims

1. Arrangement for producing a contact between a waveguide (1) or housing, which consists of a base part (2) and a cover part (3), and a planar microwave circuit (10) inserted therein, wherein the base part (2) and the cover part (3) form at at least one side wall of the waveguide (1) or housing a groove-shaped recess (4) which serves for the reception of an electrically conductive spring element (5; 15; 24), which produces the contact between the waveguide (1) or housing and the planar microwave circuit (10), characterised thereby that the spring element (5; 15; 24) has at its side intended for the insertion into the groove-shaped recess (4) two resilient lips (6, 7; 17, 18; 25, 26), of which one within the groove-shaped recess (4) presses against the base part (2) and the other presses in opposite direction against the cover part (3), and that the side of the spring element (5; 15; 24) opposite the resilient lips (6, 7; 17, 18; 25; 26) is constructed for connection with the planar microwave circuit (10, 21).

2. Arrangement according to claim 1, characterised thereby that the resilient element (5) is a profile strip, in one longitudinal side of which an elongate U-shaped cut-out (8) is present, wherein the two U limbs form the resilient lips (6, 7).

3. Arrangement according to claim 1, characterised thereby that the resilient element (15) is a profile strip, in one longitudinal side of which two parallelly running U-shaped cut-outs (19, 20) extend, wherein the respective outwardly disposed, mutually remote U limbs of the cut-outs form the two resilient lips (17, 18).

4. Arrangement according to claim 2 or 3, characterised thereby that in each U-shaped cut-out (8, 19, 20, 27, 28) the transition to the U limb forming a resilient lip (6, 7; 17, 18; 25, 26) is rounded off.

5. Arrangement according to claim 1, 2 or 3, characterised thereby that a longitudinally extending groove (9; 16) is let into the longitudinal side of the spring element (5; 15) opposite the resilient lips (6, 7; 17, 18), into which the planar microwave circuit (10) is plugged by one edge and a contact is produced between the ground line (11) in the edge zone of the planar microwave circuit and the spring element (5; 15).

6. Arrangement according to claim 5, characterised in that the mutually opposite boundary walls of the groove (9) resiliently rest on the upper side and the lower side of the planar microwave circuit (10).

7. Arrangement according to one of the preceding claims, characterised thereby that the spring element (5; 15) has at least one passage (13), which extends from the longitudinal side provided with the resilient lips (6, 7; 17, 18) to the opposite longitudinal side contactable by the planar microwave circuit (10) and which serves for guidance through of a conductor (14a), which issues through a wall of the waveguide (1) or housing and which is intended for connection to the planar microwave circuit (10).

8. Arrangement according to claim 1, 2 or 3, characterised thereby that in the case of a planar microwave circuit (10), which is to be inserted into a waveguide (1) or a housing, in the form of a metal plate (21) a spring element (24) with two resilient lips (25, 26) is directly shaped on at at least one edge of this metal plate (21).

## Revendications

1. Dispositif pour établir un contact entre un guide d'ondes creux ou un boîtier constitué d'une partie formant un fond (2) et d'une partie formant un couvercle (3) et un circuit planaire à micro-ondes (10) placé dans celui-ci, dispositif dans lequel le fond (2) et le couvercle (3) définissent, sur au moins une paroi latérale du guide d'ondes (1) ou du boîtier, une gorge (4) semblable à une rainure qui sert à la réception d'un élément élastique (5; 15; 24) électriquement conducteur et établit le contact entre le guide d'ondes (1) ou le boîtier et le circuit planaire à micro-ondes (10), caractérisé en ce que l'élément élastique (5; 15; 24) comporte, sur son côté destiné à être engagé dans la gorge (4) semblable à une rainure, deux lèvres élastiques (6, 7; 17, 18; 25, 26) dont l'une exerce une pression sur le fond (2) à l'intérieur de la gorge (4) semblable à une rainure et l'autre lèvre exerce une pression en direction contraire sur le couvercle (3), et que le côté de l'élément élastique (5; 15; 24) situé à l'opposé des lèvres élastiques (6, 7; 17, 18; 25, 26) est conçu pour la liaison au circuit planaire à micro-ondes (10, 21).

2. Dispositif selon la revendication 1, caractérisé en ce que l'élément élastique (5) est une baguette profilée présentant dans l'un des côtés longitudinaux un évidement en U (8) de forme allongée et dont les deux branches du U forment les lèvres élastiques (6, 7).

3. Dispositif selon la revendication 1, caractérisé en ce que l'élément élastique (5) est une baguette profilée dans l'un des côtés longitudinaux de laquelle s'étendent deux évidements parallèles en U (19, 20), l'agencement étant tel que les branches des évidements en U situées à l'extérieur et qui ne sont pas voisines, forment les deux lèvres élastiques (17, 18).

4. Dispositif selon la rcvendication 2 ou 3, caractérisé en ce que, dans chaque évidement en U (8, 19, 20, 27, 28), le raccordement à une branche du U formant une lèvre élastique (6, 7; 17, 18; 25, 26) est arrondi.

5. Dispositif selon la revendication 1, 2 ou 3, caractérisé en ce que le côté longitudinal de l'élément élastique (5; 15) situé à l'opposé des lèvres élastiques (6, 7; 17, 18), est pourvu d'une rainure (9; 16) s'étendant longitudinalement, dans laquelle le circuit planaire à micro-ondes (10) est engagé par un bord et dans laquelle un contact est établi entre une ligne de masse (11) située dans la zone du bord du circuit planaire à micro-ondes et l'élément élastique (5; 15).

6. Dispositif selon la revendication 5, caractérisé en ce que les flancs opposés de la rainure (9) sont appliqués élastiquement contre le côté supérieur et le côté inférieur du circuit planaire à micro-ondes (10).

7. Dispositif selon une des revendications précédentes, caractérisé en ce que l'élément élastique (5; 15) comporte au moins un perçage (13), s'étendant depuis le côté longitudinal pourvu des lèvres élastiques (6, 7; 17, 18) jusqu'au côté longitudinal opposé, pouvant être mis en contact avec le circuit planaire à micro-ondes (10), perçage qui sert à la traversée d'un conducteur (14a) pénétrant à travers une paroi du guide d'ondes (1) ou du boîtier et destiné à être raccordé au circuit planaire à micro-ondes (10).

8. Dispositif selon la revendication 1, 2 ou 3, caractérisé en ce que, au cas où le circuit planaire à micro-ondes (10) à placer dans le guide d'ondes (1) ou le boîtier se présente sous la forme d'une plaque métallique (21), un élément élastique (24) comprenant deux lèvres élastiques (25, 26) est formé directement sur au moins un bord de cette plaque métallique (21).
